# EUROPEAN PATENT APPLICATION

(11) **EP 4 148 808 A1**
(43) Date of publication of application: **15.03.2023**
(21) Application number: 21201228.0
(22) Date of filing: 06.10.2021
(51) Int. Cl.: H01L 31/0216, H01L 31/0236, H01L 31/18

(54) **SOLAR CELL, METHOD FOR MANUFACTURING SOLAR CELL, AND PHOTOVOLTAIC MODULE**

(30) Priority: 14.09.2021 CN 202111074502
(71) Applicant: Zhejiang Jinko Solar Co., Ltd., Haining, Zhejiang 314416 (CN)
(72) Inventor: ZHANG, Xiaowen, HAINING, 314416 (CN); LI, Wenqi, HAINING, 314416 (CN); YU, Ding, HAINING, 314416 (CN); ZHAO, Shijie, HAINING, 314416 (CN); CHAI, Jialei, HAINING, 314416 (CN); YANG, Jie, HAINING, 314416 (CN); ZHANG, Xinyu, HAINING, 314416 (CN); JIN, Hao, HAINING, 314416 (CN)
(74) Representative: DREISS Patentanwälte PartG mbB

(57) **Abstract**

Provided are a solar cell, a method for manufacturing a solar cell and a photovoltaic module. The solar cell includes a semiconductor substrate including a surface having a first texture structure and a first passivation layer located on the first texture structure of the semiconductor substrate. The first texture structure includes a pyramid-shaped microstructure, a length of a bevel edge of the pyramid-shaped microstructure is C µm, and 0.4≤C≤1.9. A nonuniformity of the first passivation layer is N≤4%, and N=(Dₘₐₓ-Dₘᵢₙ)/Dₘₐₓ. Dmax is a maximum thickness of the first passivation layer on the pyramid-shaped microstructure, and Dₘᵢₙ is a minimum thickness of the first passivation layer on the pyramid-shaped microstructure.

## Description

### TECHNICAL FIELD

The present disclosure relates to the field of photovoltaic cell technologies, and in particular, to a solar cell, a method for manufacturing a solar cell and a photovoltaic module.

### BACKGROUND

Thickness uniformity of film layers on a textured structure of a silicon substrate of a solar cell is a precondition for a stable passivation effect and a uniform appearance color of the solar cell. For solar cells currently manufactured in the industry, a passivation film is generally deposited on a surface of the silicon substrate, so as to achieve passivation and antireflection. However, due to an excessive number of film layers stacked, uniformity of deposition of the film layers on a surface of a textured pyramid is becoming worse, resulting in chromatic aberration of the solar cell. Such non-uniformity may adversely affect the passivation effect, resulting in a lower open-circuit voltage. In addition, the non-uniformity of the film layers may further worsen the matching between the film layers and metal paste, which leads to a reduction in a short-circuit current and a fill factor of the solar cell, thereby reducing conversion efficiency of the solar cell.

### SUMMARY

In view of the above, a solar cell, a method for manufacturing a solar cell and a photovoltaic module are provided, which can improve uniformity of a first passivation layer deposited and an antireflection effect of the first passivation layer.

In a first aspect of the present disclosure, a solar cell is provided. The solar cell includes: a semiconductor substrate including a surface having a first texture structure and a first passivation layer located on the first texture structure of the semiconductor substrate. The first texture structure includes a pyramid-shaped microstructure, a length of a bevel edge of the pyramid-shaped microstructure is C µm, and 0.4≤C≤1.9. A non-uniformity of the first passivation layer is N≤4%, and N=(Dₘₐₓ-Dₘᵢₙ)/Dₘₐₓ. Dₘₐₓ is a maximum thickness of the first passivation layer on the pyramid-shaped microstructure, and Dₘᵢₙ is a minimum thickness of the first passivation layer on the pyramid-shaped microstructure.

In some embodiments, the maximum thickness of the first passivation layer on the pyramid-shaped microstructure is in a range of 70 nm≤Dₘₐₓ≤180 nm, or the minimum thickness of the first passivation layer on the pyramid-shaped microstructure is in a range of 50 nm≤Dₘᵢₙ≤70 nm.

In some embodiments, a one-dimensional size of a bottom of the pyramid-shaped microstructure is A µm, and 0.1≤A≤3, or a height from a top to a bottom of the pyramid-shaped microstructure is B µm, and 0.1≤B≤3.

In some embodiments, a region having a maximum thickness in the first passivation layer is located at a top or a bottom of the pyramid-shaped microstructure, and a region having a minimum thickness in the first passivation layer is located between the top and the bottom of the pyramid-shaped microstructure.

In some embodiments, the first passivation layer includes a dielectric layer and K antireflection layers, K is an integer being greater than or equal to 2 and less than or equal to 7, and refractive indexes of the antireflection layers sequentially decrease as distances of the antireflection layers from the semiconductor substrate increase.

In some embodiments, the dielectric layer includes at least one of an aluminum-containing oxide, a gallium-containing oxide, a silicon-containing oxide, a titanium-containing oxide, a hafnium-containing oxide, a nickel-containing oxide, a platinum-containing oxide or a tantalum-containing oxide.

In some embodiments, the dielectric layer has a thickness in a range of 1 nm to 20 nm.

In some embodiments, the antireflection layer includes a compound composed of at least two of silicon, nitrogen or oxygen.

In some embodiments, the antireflection layer has a single-layer thickness in a range of 1 nm to 50 nm.

In some embodiments, the first passivation layer has a total thickness in a range of 70 nm to 150 nm, or an overall reflectivity of the first passivation layer is in a range of 1.5 to 2.5, and preferably 1.5 to 1.8.

In a second aspect, a photovoltaic module is provided. The photovoltaic module includes a plurality of solar cell strings, and each solar cell string includes multiple solar cells described above.

In a third aspect, a method for manufacturing a solar cell is provided. The method includes the following steps: texturing a semiconductor substrate by forming a first texture structure on a surface of the semiconductor substrate, and depositing a first passivation layer on the first texture structure of the surface of the semiconductor substrate. The first texture structure includes a pyramid-shaped microstructure, a length of a bevel edge of the pyramid-shaped microstructure is C, and 0.4 µm≤C≤1.9 µm. A non-uniformity of the first passivation layer is N≤4%.

In some embodiments, the step of texturing a semiconductor substrate includes: cleaning the surface of the semiconductor substrate with a mixture of a potassium hydroxide solution at a concentration of X% and a hydrogen peroxide solution at a concentration of Y%, and a product of X% and Y% is in a range of 0.005 to 0.285.

In some embodiments, the potassium hydroxide solution is at a concentration of X%, 5≤X≤25.

In some embodiments, the hydrogen peroxide solution is at a concentration of Y%, 7≤Y≤25.

### BRIEF DESCRIPTION OF DRAWINGS

In order to better illustrate the technical solutions in embodiments of the present disclosure or the related art, the accompanying drawings used in the description of the embodiments or the related art will be briefly introduced below. It is apparent that, the accompanying drawings in the following description are only some embodiments of the present disclosure, and other drawings can be obtained by those of ordinary skill in the art from the provided drawings without creative efforts.
FIG. 1 is a schematic structural diagram of a solar cell according to one or more embodiments of the present disclosure.
FIG. 2a is a schematic electron micrograph of a first texture structure on a front surface of a semiconductor substrate of a solar cell according to one or more embodiments of the present disclosure.
FIG. 2b is a schematic structural diagram of a pyramid-shaped microstructure on a front surface of a semiconductor substrate of a solar cell according to one or more embodiments of the present disclosure.
FIG. 2c is a schematic diagram of a one-dimensional size of a bottom of a pyramid-shaped microstructure on a front surface of a semiconductor substrate of a solar cell according to one or more embodiments of the present disclosure.
FIG. 2d is a schematic structural diagram of a first passivation layer formed on a pyramid-shaped microstructure of a front surface of a semiconductor substrate of a solar cell according to one or more embodiments of the present disclosure.
FIG. 2e is a schematic structural diagram of a first passivation layer formed on a pyramid-shaped microstructure of a front surface of a semiconductor substrate of a solar cell according to the related art.
FIG. 3a is a schematic diagram of a forming state of a first passivation layer on a front surface of a semiconductor substrate of a solar cell according to one or more embodiments of the present disclosure.
FIG. 3b is a schematic diagram of another forming state of a first passivation layer on a front surface of a semiconductor substrate of a solar cell according to one or more embodiments of the present disclosure.
FIG. 3c is a schematic diagram of yet another forming state of a first passivation layer on a front surface of a semiconductor substrate of a solar cell according to one or more embodiments of the present disclosure.
FIG. 4 is a schematic structural diagram of another solar cell according to one or more embodiments of the present disclosure.
FIG. 5 is a schematic structural diagram of a photovoltaic module according to one or more embodiments of the present disclosure.
FIG. 6 is a schematic flowchart of a method for manufacturing a solar cell according to one or more embodiments of the present disclosure.
FIG. 7 is a schematic diagram of variations of conversion efficiency, non-uniformity and a bevel-edge length of a solar cell according to one or more embodiments of the present disclosure.

### DESCRIPTION OF EMBODIMENTS

In order to better understand the technical solutions according to the present disclosure, embodiments of the present disclosure are described in detail below with reference to the accompanying drawings.

It should be understood that the described embodiments are merely some of rather than all of the embodiments of the present disclosure. All other embodiments acquired by those skilled in the art without creative efforts based on the embodiments of the present disclosure shall fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "said", and "the" are intended to include plural forms, unless otherwise clearly specified by the context.

It is to be understood that the term "and/or" used herein describes an association relationship between associated objects and represents that three relationships may exist. For example, A and/or B may represent the following three cases: only A exists, both A and B exist, and only B exists. In addition, the character "/" generally indicates an "or" relationship between the associated objects.

Thickness uniformity of film layers on a textured structure of a silicon substrate of a solar cell is a precondition for a stable passivation effect and a uniform appearance color of the solar cell. For solar cells currently manufactured in the industry, a passivation film is generally deposited on a surface of the silicon substrate, so as to achieve passivation and antireflection. However, due to an excessive number of stacked film layers, non-uniformity of deposition of the film layers on a surface of a textured pyramid is increasingly worse, resulting in chromatic aberration of the solar cell. At the same time, such non-uniformity may affect a passivation effect thereof, resulting in a lower open-circuit voltage. At the same time, the non-uniformity of the film layers may further worsen the matching between the film layers and metal paste, which leads to a reduction in a short-circuit current and a fill factor of the solar cell, thereby reducing conversion efficiency of the solar cell.

Based on this, in a first aspect, a solar cell is provided. The solar cell includes a semiconductor substrate and a first passivation layer. A surface of the semiconductor substrate has a first texture structure, and the first texture structure includes a pyramid-shaped microstructure. A length of a bevel edge of the pyramid-shaped microstructure is C µm, and 0.4≤C≤1.9. The first passivation layer is located on the first texture structure of the semiconductor substrate. The non-uniformity of the first passivation layer is N≤4%, N=(Dₘₐₓ-Dₘᵢₙ)/Dₘₐₓ. Dₘₐₓ is a maximum thickness of the first passivation layer on the pyramid-shaped microstructure, and Dₘᵢₙ is a minimum thickness of the first passivation layer on the pyramid-shaped microstructure.

In some embodiments, the size of the length of the bevel edge of the pyramid-shaped microstructure is controlled within a range of 0.4 µm to 1.9 µm, so that a gas source configured to form the first passivation layer has a similar deposition probability when deposited to the top, the bottom, and a position between the top and the bottom of the pyramid-shaped microstructure. As a result, the thickness uniformity of the first passivation layer on the pyramid-shaped microstructure is improved, so as to improve a passivation effect of the first passivation layer and increase an open-circuit voltage of the solar cell. In addition, the improvement of the uniformity of the first passivation layer may further increase a degree of matching between the first passivation layer and metal paste, which effectively reduces contact resistivity, increases a short-circuit current and a fill factor of the solar cell, and thereby improving conversion efficiency of the solar cell.

In the present disclosure, the technical solution according to the present disclosure is introduced in detail by taking a tunnel oxide passivated contact (TOPCon) cell as an example.

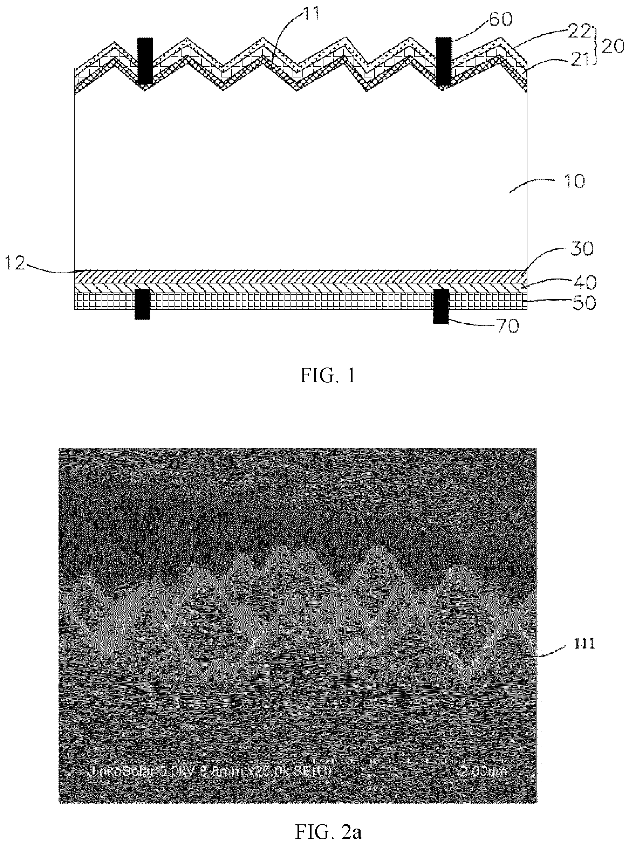

FIG. 1 is a schematic structural diagram of a solar cell according to one or more embodiments of the present disclosure. As shown in FIG. 1, the solar cell includes: a semiconductor substrate 10, a first passivation layer 20 located on a first texture structure 11 of the semiconductor substrate 10, a tunneling layer 30 located on a rear surface of the semiconductor substrate 10, a doped conductive layer 40 located on a surface of the tunneling layer 30, and a second passivation layer 50 located on a surface of the doped conductive layer 40. A front surface of the semiconductor substrate 10 has a first texture structure 11, and the first texture structure 11 includes a pyramid-shaped microstructure. A length of a bevel edge of the pyramid-shaped microstructure is C µm, and 0.4≤C≤1.9. A non-uniformity of the first passivation layer 20 is N≤4%.The doped conductive layer 40 has a doping element of a same conductivity type as the semiconductor substrate 10.

It is noted that the front surface of the semiconductor substrate 10 may refer to a light-receiving surface, that is, a surface receiving sun rays (light-receiving surface), and the rear surface of the semiconductor substrate 10 refers to a surface opposite to the front surface. In some embodiments, the formed solar cell is a single-sided solar cell, the front surface may refer to a light-receiving surface, and the rear surface may refer to a backlight surface. In some embodiments, the formed solar cell is a double-sided solar cell, and both the front surface and the rear surface may be light-receiving surfaces.

In some embodiments, the semiconductor substrate 10 is an N-type crystalline silicon substrate (or silicon wafer), and a P-type doped layer may be formed on the front surface of the semiconductor substrate by any one or more processes of high-temperature diffusion, paste doping and ion implantation, so as to form a PN junction in the semiconductor substrate 10. In some embodiments, the semiconductor substrate 10 may be one of a monocrystalline silicon substrate, a polycrystalline silicon substrate, a microcrystalline silicon substrate or a silicon carbide substrate.

In some embodiments, the P-type doped layer is a boron-doped diffusion layer. The boron-doped diffusion layer is a P-type doped layer (i.e., P+ layer) formed by using a boron source to diffuse boron atoms to a certain depth on the front surface through a diffusion process. For example, the boron source may be liquid boron tribromide.

In some embodiments, as shown in FIG. 2a, the front surface of the semiconductor substrate 10 has a first texture structure 11, and the first texture structure 11 includes a pyramid-shaped microstructure 111. The pyramid-shaped microstructure 111 may have a structure of a tetrahedron, a substantial tetrahedron, a pentahedron, a substantial pentahedron, or the like. The pyramid-shaped microstructure 111 may be formed by texturing the semiconductor substrate. The texturing may be performed by chemical etching, laser etching, a mechanical processing, plasma etching or the like. The pyramid-shaped microstructure enables metal paste to better fill the microstructure when the metal paste forms an electrode by screen printing, so as to obtain a better electrode contact, which can effectively reduce serial resistance of the solar cell and increase the fill factor.

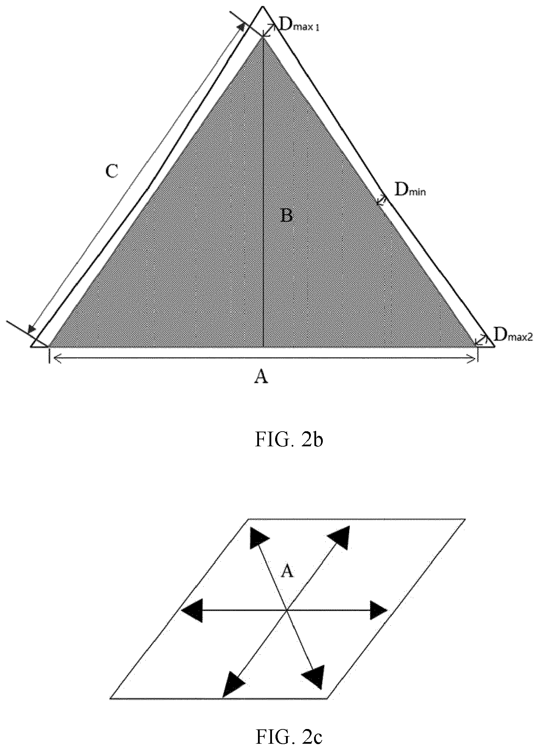

In some embodiments, as shown in FIG. 2b, a length of a bevel edge of the pyramid-shaped microstructure 111 is C µm, and 0.4≤C≤1.9. The length of the bevel edge of the pyramid-shaped microstructure 111 may be 0.4 µm, 0.5 µm, 0.6 µm, 0.8 µm, 1.0 µm, 1.2 µm, 1.4 µm, 1.5 µm, 1.6 µm, 1.8 µm, 1.9 µm or the like. A one-dimensional size of a bottom of the pyramid-shaped microstructure 111 is A µm, and 0.1≤A≤3. As shown in FIG. 2c, the one-dimensional size A of the bottom may be a length, width, diagonal length, circular diameter or the like of a bottom surface, which is not limited herein. In some embodiments, the one-dimensional size may refer to an average value of one-dimensional sizes of bottom surfaces of a plurality of pyramid-shaped microstructures in a preset range of the front surface of the substrate. For example, the one-dimensional size A of the bottom of the pyramid-shaped microstructure 111 may be 0.1 µm, 0.5 µm, 0.8 µm, 1.0 µm, 1.5 µm, 1.8 µm, 2 µm, 2.5 µm, 2.8 µm, 3 µm or the like.

A height from top to bottom of the pyramid-shaped microstructure is B µm, and 0.1≤B≤3. A vertical distance from top to bottom of the pyramid-shaped microstructure may be 0.1 µm, 0.5 µm, 0.8 µm, 1.0 µm, 1.5 µm, 1.8 µm, 2 µm, 2.5 µm, 2.8 µm, 3 µm or the like.

In some examples, when being measured, a texture size feature characterizing the first texture structure or second texture structure of the solar cell may be directly measured and calibrated through a test instrument (an optical microscope, an atomic force microscope, a scanning electron microscope, a transmission electron microscope, or the like). For example, the one-dimensional size of the bottom surface of the pyramid-shaped microstructure and the height from top to bottom of the pyramid-shaped microstructure. In some embodiments, a test method for the one-dimensional size of the bottom of the pyramid-shaped microstructure 111 includes: randomly selecting 10 or more pyramid-shaped microstructures from the first texture structure, measuring the one-dimensional size of the bottom thereof through the test instrument, and then calculating an average value of a plurality of one-dimensional sizes to obtain the one-dimensional size of the bottom of the pyramid-shaped microstructure 111. The thickness of the first passivation layer 20 refers to a thickness of the first passivation layer 20 relative to a formation surface. The above measurement manners are examples only and are not limited in the present disclosure.

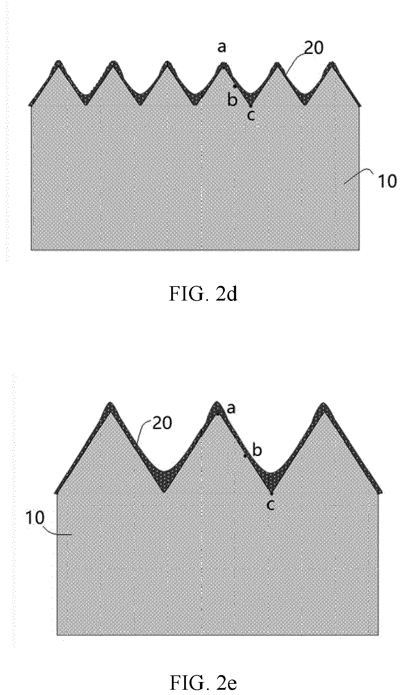

As shown in FIG. 2d and FIG. 2e, in the first passivation layers 20 formed on a same pyramid-shaped microstructure 111, the first passivation layers 20 located at a top a and/or a bottom c of the pyramid-shaped microstructure 111 has a greater thickness, and the first passivation layers 20 located between the top a and the bottom c of the pyramid-shaped microstructure 111 has a smaller thickness.

In the present disclosure, the thickness of the first passivation layer 20 on the pyramid-shaped microstructure 111 may be measured by using a high-resolution device such as a transmission electron microscope (TEM). Upon measurement, a maximum thickness of the first passivation layer 20 on the pyramid-shaped microstructure 111 is Dₘₐₓ, a minimum thickness of the first passivation layer 20 on the pyramid-shaped microstructure 111 is Dₘᵢₙ, non-uniformity N of the first passivation layer 20 is defined as N=(Dₘₐₓ-Dₘᵢₙ)/Dₘₐₓ, and the non-uniformity of the first passivation layer 20 is N≤4%.

For example, the non-uniformity N of the first passivation layer 20 may be 4%, 3.5%, 3%, 2.8%, 2.5%, 2%, 1.8%, 1.5%, 1% or the like, which is not limited herein. The non-uniformity of the first passivation layer 20 is controlled within the above range, the front surface of the solar cell has the most uniform color, passivation and antireflection effects are optimal, and thus the conversion efficiency of the solar cell may be improved.

As shown in FIG. 2d, a maximum-thickness region in the first passivation layer on the pyramid-shaped microstructure is located at the top a or the bottom c of the pyramid-shaped microstructure. In some embodiments, during the testing, the thickness of the first passivation layers located at the top of the same pyramid-shaped microstructure may be denoted as Dₘₐₓ₁, the thickness of the first passivation layers located at the bottom of the same pyramid-shaped microstructure may be denoted as Dₘₐₓ₂, and the maximum thickness of the first passivation layer 20 on the pyramid-shaped microstructure is Dₘₐₓ=(Dₘₐₓ₁+Dₘₐₓ₂)/2. Thicknesses of a plurality of passivation layers are tested respectively from top to bottom, and a sample number is greater than or equal to 10. The minimum thickness of the first passivation layer 20 is calculated as Dₘᵢₙ. In some other embodiments, during the testing, thicknesses of a plurality of passivation layers on a same pyramid-shaped microstructure may be tested respectively from top to bottom, and the sample number is greater than or equal to 10. The thicknesses obtained by sampling are compared to obtain Dₘₐₓ and Dmin.

For example, 70 nm≤Dₘₐₓ≤180 nm, which may be 70 nm, 80 nm, 90 nm, 100 nm, 110 nm, 120 nm, 150 nm, 160 nm, 180 nm or the like, and may also be other values in the above range, which is not limited herein.

A minimum-thickness region in the first passivation layer on the pyramid-shaped microstructure is located between the top and the bottom of the pyramid-shaped microstructure. The minimum thickness of the first passivation layer 20 is in a range of 50 nm≤Dₘᵢₙ≤70 nm, which may be 50 nm, 56 nm, 58 nm, 60 nm, 62 nm, 65 nm, 68 nm, 70 nm or the like, and may also be other values in the above range, which is not limited herein.

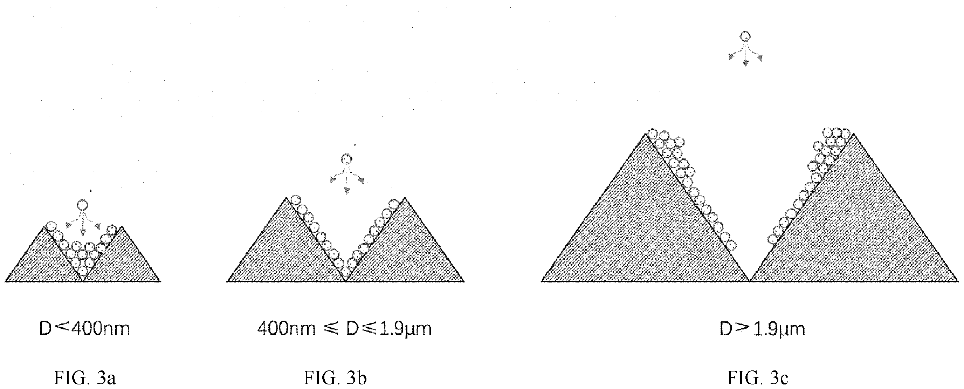

As shown in FIG. 3a, when the length of the bevel edge of the pyramid-shaped microstructure 111 is less than 400 nm (i.e., 0.4 µm), the first passivation layer 20 is deposited on the pyramid-shaped microstructure 111 by a plasma vapor deposition process. Since the length of the bevel edge is too small, diffusion paths from plasma to the bottom, from the middle and from the top of the pyramid-shaped microstructure are basically the same. Under gravity, the probability of deposition at the bottom of the pyramid-shaped microstructure increases, which leads to more easier formation of a passivation layer at the bottom of the pyramid-shaped microstructure, thus easily causes the thickness of the passivation layer deposited at the bottom to be thicker than that deposited at the top, and the uniformity of the passivation layer may decrease.

As shown in FIG. 3c, when the length of the bevel edge of the pyramid-shaped microstructure 111 is greater than 1.9 µm, the first passivation layer 20 is deposited on the pyramid-shaped microstructure 111 by a plasma vapor deposition process. Since the length of the bevel edge is too large, the diffusion path from the plasma to the bottom of the pyramid-shaped microstructure may be much greater than the diffusion path from the plasma to the top of the pyramid-shaped microstructure. The probability of deposition at the top of the pyramid-shaped microstructure increases. As a result, only a small amount of the plasma may reach the bottom, the thickness of the top of the pyramid-shaped microstructure is greater than that of the passivation layer deposited at the bottom, and the uniformity of the passivation layer may decrease.

Therefore, in a case where process deposition parameters are kept stable, the thickness of the first passivation layer at a same position may gradually decrease until it becomes stable when a groove depth of the pyramid-shaped microstructure 111 increases. The greater the curvature is, the thicker the first passivation layer is deposited within a same time. The length of the bevel edge of the pyramid-shaped microstructure 111 is controlled within the range of 0.4 µm to 1.9 µm, so that a gas source configured to form the first passivation layer has similar deposition probability when diffused and deposited to various positions of the pyramid-shaped microstructure. Therefore, the first passivation layer deposited at various positions of the pyramid-shaped microstructure has better thickness uniformity. In some embodiments, lengths of bevel edges of a plurality of pyramid-shaped microstructures in the first texture structure 11 are randomly collected and an average value thereof is calculated. The average value is defined as the length of the bevel edge of the pyramid-shaped microstructure. For example, 4 pyramid-shaped microstructures 111 are randomly selected, with lengths of bevel edges being C1, C2, C3 and C4 respectively, and the length of the bevel edge of the pyramid-shaped microstructure 111 is (C1+C2+C3+C4)/4.

In some embodiments, the first passivation layer 20 includes a dielectric layer 21 and K antireflection layers 22 that are stacked, K is an integer being greater than or equal to 2 and less than or equal to 7, and refractive indexes of the antireflection layers 22 decrease sequentially as distances from the semiconductor substrate increase.

The dielectric layer 21 includes at least one of an aluminum-containing oxide, a gallium-containing oxide, a silicon-containing oxide, a titanium-containing oxide, a hafnium-containing oxide, a nickel-containing oxide, a platinum-containing oxide or a tantalum-containing oxide. For example, the dielectric layer 21 may include at least one of an aluminum oxide layer, a gallium oxide layer, a silicon oxide layer, a titanium oxide layer, a hafnium oxide layer, or the like.

In some embodiments, the dielectric layer 21 has a thickness in a range of 1 nm to 20 nm, which may be 1 nm, 5 nm, 8 nm, 9 nm, 10 nm, 12 nm, 15 nm, 18 nm, 20 nm or the like, and may also be other values in the above range, which is not limited herein.

The antireflection layer 22 includes a compound composed of at least two elements of silicon, nitrogen and oxygen. For example, the antireflection layer is selected from a stack structure of at least one or more of a silicon oxide layer, a silicon nitride layer or a silicon oxynitride layer.

The antireflection layer 22 has a single-layer thickness in a range of 1 nm to 50 nm, which may be 1 nm, 5 nm, 10 nm, 20 nm, 30 nm, 35 nm, 40 nm, 45 nm, 50 nm or the like, and may also be other values in the above range, which is not limited herein.

Refractive indexes of the antireflection layers 22 decrease sequentially as distances from the semiconductor substrate increase, so as to enhance the passivation effect of the first passivation layer.

Overall reflectivity of the first passivation layer 20 is in a range of 1.5 to 2.5, which may be 1.5, 1.6, 1.8, 1.9, 2.0, 2.2, 2.4, 2.5 or the like, and is not limited therein. The overall reflectivity of the first passivation layer 20 may be in a range of 1.5 to 1.8.

The first passivation layer 20 has a total thickness in a range of 70 nm to 150 nm, which may be 70 nm, 80 nm, 85 nm, 90 nm, 95 nm, 100 nm, 110 nm, 120 nm, 130 nm, 150 nm or the like, and is not limited herein.

In some embodiments, as shown in FIG. 1, the rear surface of the semiconductor substrate 10 has a second texture structure 12. For example, the second texture structure 12 may be formed by alkali chemical polishing.

In some embodiments, the second texture structure on the rear surface of the semiconductor substrate includes two or more first substructures at least partially stacked on one another. The second texture structure presents a shape of a non-pyramid-shaped microstructure.

For the two or more first substructures, in a direction away from the rear surface and perpendicular to the rear surface (which may also be understood as in a stacking direction), a distance H between a top surface of the outermost first substructure and a top surface of the first substructure adjacent thereto is less than or equal to 2 µm, which may be 2 µm, 1.8 µm, 1.5 µm, 1.2 µm, 1.1 µm, 1.0 µm, 0.8 µm, 0.5 µm, 0.3 µm, 0.2 µm, 0.1 µm or the like. When three layers of first substructures are stacked, a distance H between a top surface of the first substructure of any layer and a top surface of the first substructure of an adjacent layer is less than or equal to 2 µm.

A one-dimensional size L of the top surface of the outermost first substructure is less than or equal to 45 µm. That is, 0<L≤45 µm. For example, the one-dimensional size L is in a range of 2 µm to 45 µm. The one-dimensional size L of the top surface may be a length, width, diagonal length, circular diameter or the like of the surface, which is not limited herein. In some embodiments, the one-dimensional size may refer to an average value of one-dimensional sizes of top surfaces of a plurality of outermost first substructures in a preset range of the rear surface of the substrate. An average value of the one-dimensional sizes of the top surfaces of the plurality of outermost first substructures may be 2 µm, 5 µm, 8 µm, 12 µm, 15 µm, 18 µm, 20 µm, 25 µm, 28 µm, 30 µm, 35 µm, 40 µm, 42 µm, 40 µm, 45 µm or the like.

In some examples, due to subsequent manufacturing of the first passivation layer, such as the first passivation layer 20, the tunneling layer 30 and the doped conductive layer 40, the second texture structure and an initial structure of the first texture structure may be damaged. For example, in a mass-produced solar cells, the first texture structure may further include a small number of non-pyramid-shaped microstructures formed due to damages to tips of the pyramid-shaped microstructures.

As shown in FIG. 1, a tunneling layer 30 is located on the second texture structure 12 of the rear surface of the semiconductor substrate 10. The tunneling layer 30 may be a stack structure of one or more of a silicon oxide layer, an aluminum oxide layer, a silicon oxynitride layer, a molybdenum oxide layer or a hafnium oxide layer. In some other embodiments, the tunneling layer 30 may also be an oxygen-containing silicon nitride layer, an oxygen-containing silicon carbide layer, or the like. The tunneling layer 30 has a thickness in a range of 0.8 nm to 2 nm. For example, the thickness of the tunneling layer 30 is 0.8 nm, 0.9 nm, 1.0 nm, 1.2 nm, 1.4 nm, 1.6 nm, 1.8 nm, 2 nm or the like. The thickness of the tunneling layer 30 refers to a thickness of the tunneling layer 30 relative to a formation surface. The thickness of the tunneling layer 30 formed on the second texture structure may be calculated by taking a normal direction of a bevel of the substrate as a thickness direction and observing a cross section thereof. The tunneling layer 30 with an excessive large thickness is not conducive to reduce contact resistance of the tunneling layer. Reduction of the fill factor caused by the contact resistance may be inhibited by controlling the thickness of the tunneling layer.

In some embodiments, a bandgap width of the tunneling layer 30 is greater than 3.0 eV, and it is generally difficult to transport carriers through the tunneling layer 30 by thermal emission. However, since the tunneling layer 30 is very thin, the carriers may pass through the tunneling layer 30 through a tunneling effect. Therefore, the tunneling layer with a thickness in the range of 0.8 nm to 2 nm does not block the transport of most carriers. As the thickness of the tunneling layer gradually increases, the tunneling effect of most carriers is adversely affected, and it is difficult to transport the carriers through the tunneling layer 30, and the photoelectric conversion efficiency of the solar cell may gradually decrease. The tunneling layer with an excessive small thickness cannot play a role of passivation. For example, the tunneling layer 30 is a silicon oxide layer, and the tunneling layer 30 has a thickness in a range of 0.8 nm to 1.5 nm.

In some embodiments, texture structures with different shapes are arranged on front and rear surfaces of the semiconductor structures, and a pyramid-shaped texture structure is formed on the front surface and a non-pyramid-shaped texture structure is formed on the rear surface, so that the solar cell formed has a light receiving structure at different levels, which increases an effective contact area of light, reduces contact resistivity, increases an open-circuit voltage of the solar cell, increases the fill factor, and thus improves the photoelectric conversion efficiency.

In some embodiments, the doped conductive layer 40 may include a doped polycrystalline silicon layer, a doped microcrystalline silicon layer or a doped amorphous silicon layer. The doped conductive layer 40 has a doping element of a same conductivity type as the semiconductor substrate.

When the semiconductor substrate 10 is an N-type monocrystalline silicon substrate, the doped conductive layer 40 is an N-type doped polycrystalline silicon layer, an N-type doped microcrystalline silicon layer or an N-type doped amorphous silicon layer. The doping element may be an N-type doping element such as phosphorus.

In some embodiments, the doped conductive layer 40 has a thickness in a range of 60 nm to 200 nm, which may be, for example, an N-type doped polycrystalline silicon layer. The doped conductive layer 40 has a refractive index in a range of 3.5 to 4.5.

In some embodiments, the second passivation layer 50 includes at least one of a silicon nitride layer, a silicon oxide layer or a silicon oxynitride layer. The second passivation layer 50 has a thickness in a range of 70 nm to 120 nm. For example, the second passivation layer 50 is a silicon nitride layer, and the silicon nitride layer has a low silicon-to-nitrogen ratio. The silicon nitride layer has a refractive index in a range of 1.7 to 2.1, which may be 1.7, 1.8, 1.9, 2.0, 2.1 or the like, and may also be other values in the above range, which is not limited herein. The refractive index of the silicon nitride layer is controlled to enable the silicon nitride layer to have a low silicon-to-nitrogen ratio, and the formed second passivation layer 50 can reduce the contact resistivity during metallization, thereby further reducing the contact resistivity of the solar cell.

In some embodiments, when the second passivation layer 50 has a stack structure of a silicon nitride layer and a silicon oxide layer or a stack structure of a silicon nitride layer and a silicon oxynitride layer, the silicon nitride layer is located on a surface of the doped conductive layer, and the silicon oxide layer or the silicon oxynitride layer is located on a surface of the silicon nitride layer.

The solar cell further includes a first electrode 60 and a second electrode 70. The first electrode 60 passes through the first passivation layer 20 to form an ohmic contact with the P-type doped layer (e.g., the boron-doped diffusion layer) on the front surface of the semiconductor substrate 10. The second electrode 70 passes through the second passivation layer 50 and forms an ohmic contact with the doped conductive layer 40. The doped conductive layer 40 and the tunneling layer 30 form a passivated contact structure. The first electrode 60 and the second electrode 70 may be formed by sintering metal conductive paste coated on surfaces of the first passivation layer and the second passivation layer. In some embodiments, the first electrode 60 and the second electrode 70 may be made of metal materials such as silver, aluminum, copper or nickel.

For the solar cell formed as shown in FIG. 1, that is, the first texture structure of the pyramid-shaped microstructure is formed on the front surface of the semiconductor substrate 10, and the second texture structure of a non-pyramid-shaped microstructure is formed on the rear surface of the semiconductor substrate. A first passivation layer 20 is formed on the first texture structure, non-uniformity of the first passivation layer is N≤4%. A tunneling layer 30, a doped conductive layer 40 and a second passivation layer 50 (e.g., a silicon nitride layer) are formed on the second texture structure. The obtained solar cell structure has high photoelectric conversion efficiency.

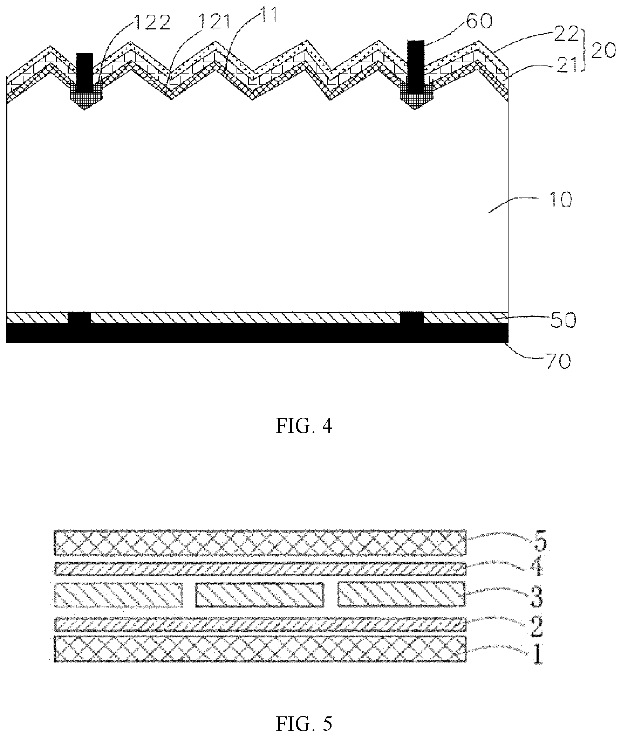

In some embodiments, the solar cell may also be a passivated emitter and rear cell (PERC) solar cell. As shown in FIG. 4, the solar cell has a structure including: a semiconductor substrate 10, a doped layer located on the front surface of the semiconductor substrate 10, a first passivation layer 20 located on the doped layer, a first electrode 60 located on the first passivation layer 20, a second passivation layer 50 located on the rear surface of the semiconductor substrate 10, and a second electrode 70 located on the rear surface of the second passivation layer 50. The semiconductor substrate 10 includes a front surface and a rear surface arranged opposite to each other. The doped layer includes a slightly-doped region 121 having a first doping concentration and a heavily-doped region 122 having a second doping concentration. A selective emitter structure is formed between the heavily-doped region 122 and the slightly-doped region 121. The first electrode 60 penetrates through the first passivation layer 20 to form an ohmic contact with the heavily-doped region 122 of the doped layer. The second passivation layer 50 is provided with an opening, and at least part of the second electrode 70 passes through the opening to form an ohmic contact with the semiconductor substrate 10.

The semiconductor substrate 10 may be a P-type crystalline silicon substrate. The types of the first passivation layer 20, the second passivation layer 50, the first electrode 60 and the second electrode 70 may be obtained with reference to the Topcon cell, which are not described in detail herein.

In some embodiments, the solar cell may also be an interdigitated back contact (IBC) cell or a heterojunction with intrinsic thinfilm (HJT) cell, which is not limited herein.

In a second aspect, one or more embodiments of a photovoltaic module including a plurality of solar cell strings is provided.

As shown in FIG. 5, the photovoltaic module includes a first cover plate 1, a first packaging adhesive layer 2, a plurality of solar cell strings 3, a second packaging adhesive layer 4 and a second cover plate 5.

The solar cell string 3 includes a plurality of solar cells (e.g., the solar cell as depicted in FIG. 1). The solar cells are connected through a conductive strip (not shown). The solar cells may be connected by partial stacking or by splicing to one another.

The first cover plate 1 and the second cover plate 5 may be transparent or opaque cover plates, such as glass cover plates or plastic cover plates.

Two sides of the first packaging adhesive layer 2 are in contact with the first cover plate 1 and the solar cell string 3, respectively, and two sides of the second packaging adhesive layer 4 are in contact with the second cover plate 1 and the solar cell string 3, respectively. The first packaging adhesive layer 2 and the second packaging adhesive layer 4 may be ethylenevinyl acetate copolymer (EVA) films, polyethylene-octene co-elastomer (POE) films or polyethylene terephthalate (PET) films, respectively.

Side edges of the photovoltaic module may also be completely packaged. That is, the side edges of the photovoltaic module are fully packaged with a packaging adhesive tape to prevent a lamination deviation during the lamination of the photovoltaic module.

In some embodiments, the photovoltaic module further includes an edge sealing member fixed and packaged to a partial edge of the photovoltaic module. The edge sealing member may be fixed and packaged to an edge near a corner of the photovoltaic module. The edge sealing member may be a high-temperature resistant tape. The high-temperature resistant tape has excellent high-temperature resistance and may not decompose or fall off during the lamination, which can ensure a reliable packaging of the photovoltaic module. Two ends of the high-temperature resistant tape are fixed to the second cover plate 5 and the first cover plate 1, respectively. The two ends of the high-temperature resistant tape may be bonded to the second cover plate 5 and the first cover plate 1, respectively, and the middle thereof can limit a side edge of the photovoltaic module to prevent a lamination deviation of the photovoltaic module during the lamination.

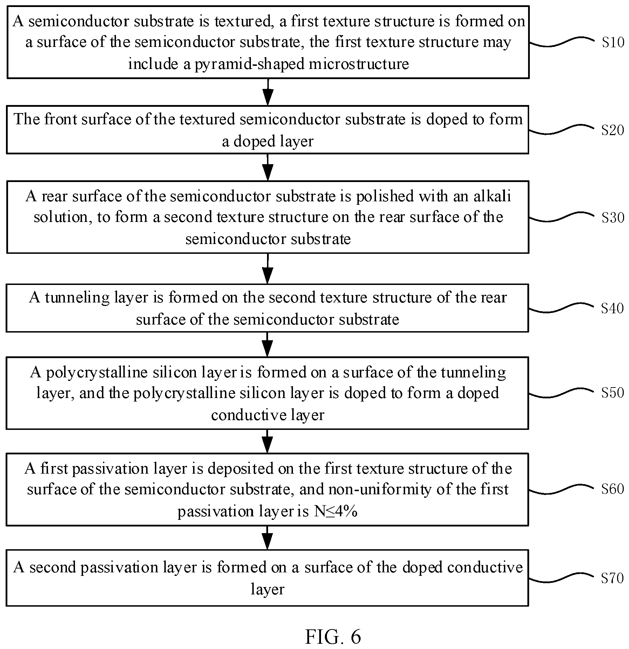

In a third aspect, the present disclosure further provides a method for manufacturing a solar cell, for manufacturing the TOPCon solar cell described above. As shown in FIG. 6, the method includes the following steps.

In S10, a semiconductor substrate is textured, a first texture structure is formed on a surface of the semiconductor substrate, the first texture structure may include a pyramid-shaped microstructure, and a length of a bevel edge of the pyramid-shaped microstructure is C µm, and 0.4≤C≤1.9.

In S20, the front surface of the textured semiconductor substrate is doped to form a doped layer.

In S30, a rear surface of the semiconductor substrate is polished with an alkali solution, to form a second texture structure on the rear surface of the semiconductor substrate.

In S40, a tunneling layer is formed on the second texture structure of the rear surface of the semiconductor substrate.

In S50, a polycrystalline silicon layer is formed on a surface of the tunneling layer, and the polycrystalline silicon layer is doped to form a doped conductive layer, the doped conductive layer and the semiconductor substrate having a doping element of a same conductivity type as the semiconductor substrate.

In S60, a first passivation layer is deposited on the first texture structure of the surface of the semiconductor substrate, and non-uniformity of the first passivation layer is N≤4%.

In S70, a second passivation layer is formed on a surface of the doped conductive layer.

In the above solution, the size of the bevel edge of the pyramid-shaped microstructure is controlled within a range of 0.4 µm to 1.9 µm, so that thickness uniformity of the first passivation layer on the pyramid-shaped microstructure is improved, so as to improve a passivation effect of the first passivation layer and increase an open-circuit voltage of the solar cell. Besides, the improvement of the uniformity of the first passivation layer may further increase a degree of matching between the first passivation layer and metal paste, which effectively reduces contact resistivity, increases a short-circuit current and a fill factor of the solar cell, and thus improving conversion efficiency of the solar cell.

The solution is introduced below.

In S10, a semiconductor substrate is textured, a first texture structure is formed on a surface of the semiconductor substrate, the first texture structure includes a pyramid-shaped microstructure, and a length of a bevel edge of the pyramid-shaped microstructure is C µm, where 0.4≤C≤1.9.

The semiconductor substrate may be a crystalline silicon substrate (silicon substrate), for example, one of a polycrystalline silicon substrate, a monocrystalline silicon substrate, a microcrystalline silicon substrate or a silicon carbide substrate. The specific type of the semiconductor substrate is not limited in embodiments of the present disclosure. In some embodiments, the semiconductor substrate is an N-type crystalline silicon substrate (or silicon wafer). The semiconductor substrate has a thickness of 60 µm to 240 µm, which may be 60 µm, 80 µm, 90 µm, 100 µm, 120 µm, 150 µm, 200 µm, 240 µm or the like, and is not limited herein. Doping elements of the semiconductor substrate may be phosphorus, nitrogen or the like.

As shown in FIG. 2a, the front surface of the semiconductor substrate 10 has a first texture structure 11, and the first texture structure 11 includes a pyramid-shaped microstructure 111. The pyramid-shaped microstructure 111 may have a structure of a tetrahedron, a substantial tetrahedron, a pentahedron, a substantial pentahedron, or the like. The pyramid-shaped microstructure 111 may be formed by texturing the semiconductor substrate. The texturing may be performed by chemical etching, laser etching, a mechanical processing, plasma etching or the like. The pyramid-shaped microstructure enables metal paste to better fill the microstructure when the metal paste forms an electrode by screen printing, so as to obtain a better electrode contact, which can effectively reduce serial resistance of the solar cell and increase a fill factor.

In some embodiments, the step of texturing a semiconductor substrate includes: cleaning the surface of the semiconductor substrate with a mixture of a potassium hydroxide solution at a concentration of X% and a hydrogen peroxide solution at a concentration of Y%, and a product of X% and Y% is in a range of 0.005 to 0.285.

For example, the potassium hydroxide solution is at a concentration of X%, 5≤X≤25. When the potassium hydroxide solution is at a concentration of 5%, 100 g of the potassium hydroxide solution contains 5 g of potassium hydroxide. The potassium hydroxide solution may be at a concentration of 5%, 8%, 10%, 12%, 15%, 18%, 20%,25% or the like. The hydrogen peroxide solution is at a concentration of Y%, 7≤Y≤25, which may be 7%, 8%, 9%, 10%, 12%, 15%, 18 %, 20 %, 22 %, 25% or the like. It is found through tests that the product of X% and Y% is controlled in the above range, which is conducive to improving the uniformity of the pyramid-shaped microstructure. It is to be noted that a concentration of a textured solution, an additive, reaction time and a reaction temperature may all affect the size of the pyramid-shaped microstructure finally manufactured.

When the N-type semiconductor substrate is an N-type monocrystalline silicon substrate, texturing is performed by using a mixture of potassium hydroxide and hydrogen peroxide. The pyramid-shaped microstructure may be manufactured due to anisotropy of corrosion of the potassium hydroxide solution.

In some embodiments, as shown in FIG. 2b, a length of a bevel edge of the pyramid-shaped microstructure 111 is C µm, and 0.4≤C≤1.9. The length of the bevel edge of the pyramid-shaped microstructure 111 may be 0.4 µm, 0.5 µm, 0.6 µm, 0.8 µm, 1.0 µm, 1.2 µm, 1.4 µm, 1.5 µm, 1.6 µm, 1.8 µm, 1.9 µm or the like.

A one-dimensional size of a bottom of the pyramid-shaped microstructure 111 is A µm, and 0.1≤A≤3. As shown in FIG. 2c, the one-dimensional size A of the bottom may be a length, width, diagonal length, circular diameter or the like of a bottom surface, which is not limited herein. In some embodiments, the one-dimensional size may refer to an average value of one-dimensional sizes of bottom surfaces of a plurality of pyramid-shaped microstructures in a preset range of the front surface of the substrate. For example, the one-dimensional size A of the bottom of the pyramid-shaped microstructure 111 may be 0.1 µm, 0.5 µm, 0.8 µm, 1.0 µm, 1.5 µm, 1.8 µm, 2 µm, 2.5 µm, 2.8 µm, 3 µm or the like.

A height from top to bottom of the pyramid-shaped microstructure is B µm, and 0.1≤B≤3.A vertical distance from top to bottom of the pyramid-shaped microstructure may be 0.1 µm, 0.5 µm, 0.8 µm, 1.0 µm, 1.5 µm, 1.8 µm, 2 µm, 2.5 µm, 2.8 µm, 3 µm or the like.

In some examples, when being measured, a texture size feature characterizing the first texture structure or second texture structure of the solar cell may be calibrated by directly measuring a surface of a film layer through a test instrument (an optical microscope, an atomic force microscope, a scanning electron microscope, a transmission electron microscope, or the like). For example, the texture size feature may be one-dimensional size of the bottom surface of the pyramid-shaped microstructure and the height from top to bottom of the pyramid-shaped microstructure. A test method for the one-dimensional size of the bottom of the pyramid-shaped microstructure 111 includes: randomly selecting 10 or more pyramid-shaped microstructures from the first texture structure, measuring the one-dimensional size of the bottom thereof through the test instrument, and then calculating an average value of a plurality of one-dimensional sizes to obtain the one-dimensional size of the bottom of the pyramid-shaped microstructure 111. The thickness of the first passivation layer 20 refers to a thickness of the first passivation layer 20 relative to a formation surface. The above measurement manners are examples only and are not limited in the present disclosure.

In S20, the front surface of the textured semiconductor substrate is doped to form a doped layer.

In some embodiments, when the semiconductor substrate 10 is an N-type substrate, a P-type doped layer may be formed on the front surface of the semiconductor substrate by any one or more processes of high-temperature diffusion, paste doping and ion implantation, so as to form a PN junction in the semiconductor substrate 10.

In some embodiments, the P-type doped layer is a boron-doped diffusion layer. The boron-doped diffusion layer is a P-type doped layer (i.e., P+ layer) formed by using a boron source to diffuse boron atoms to a certain depth on the front surface through a diffusion process. For example, the boron source may be liquid boron tribromide. A microcrystalline silicon phase of the substrate after boron diffusion treatment is transformed into a polycrystalline silicon phase. Since the surface of the semiconductor substrate has boron with a high concentration, a borosilicate glass (BSG) layer is generally formed.

Further, prior to S30 of polishing a rear surface of the semiconductor substrate with an alkali solution, the method further includes: removing the borosilicate glass layer from the rear surface of the semiconductor substrate with a prepared mixed acid, the mixed acid includes a hydrofluoric acid solution at a concentration in a range of 0.1% to 10%, a sulfuric acid solution at a concentration in a range of 10% to 20% and a nitric acid solution at a concentration in a range of 25% to 50%; and washing and drying the rear surface of the semiconductor substrate after pickling.

During the boron diffusion treatment, the rear surface of the semiconductor substrate is coated to form part of the borosilicate glass, which is required to be removed. A porous structure may appear on the rear surface of the semiconductor substrate after pickling.

For example, a pickling time ranges from 10 s to 180 s, and a pickling temperature ranges from 7°C to 20°C. That is, the borosilicate glass on the rear surface of the semiconductor substrate is pickled off at room temperature to expose the body of the semiconductor substrate.

In S30, a rear surface of the semiconductor substrate is polished with an alkali solution, so that a second texture structure is formed on the rear surface of the semiconductor substrate.

For example, the rear surface of the semiconductor substrate is cleaned with the alkali solution at a concentration in a range of 5% to 15% to remove porous silicon.

Micro-liquid droplets of the alkali solution are dropped by spraying to the rear surface of the semiconductor substrate for roughening treatment, and then pre-cleaning is performed with a hydrofluoric acid at a concentration in a range of 5% to 10%.

The rear surface of the semiconductor substrate is polished with a polishing liquid at a polishing temperature ranging from 70°C to 80°C for a polishing time less than 260 s. The polishing liquid includes NaOH at a concentration in a range of 1% to 15%, KOH at a concentration in a range of 1% to 15% and an additive at a concentration in a range of 0.5% to 2.5%.

Organic components in the etching solution are removed by a mixture of potassium hydroxide at a concentration in a range of 5% to 15% and hydrogen peroxide at a concentration in a range of 15% to 40%.

The polished semiconductor substrate is washed and dried.

In some embodiments, when the rear surface is polished, the borosilicate glass layer on the front surface of the semiconductor substrate is required to be protected, for example, by a mask.

In some embodiments, due to the low concentration of boron on the rear surface of the semiconductor substrate, the etching efficiency can be improved effectively by using the alkali solution. The alkali solution contains an organic base and/or an inorganic base. The inorganic base may be NaOH, KOH, Ga(OH)₂ or NH₃.H₂O, and the organic base may be triethylamine, nitrophenol, pyridine, quinine, colchicine or the like. The additive in the polishing liquid may be a buffer solution composed of sodium sulfonate, maleic anhydride, alkyl glycoside, or the like.

The polishing temperature may be 70°C, 72°C, 74°C, 75°C, 78°C, 79°C, 80°C or the like, and the polishing time may be 250 s, 240 s, 230 s, 220 s, 200 s, 180 s, 160 s, 140 s, 120 s, 100 s, 80 s or the like, which may also be other values in the above ranges.

In some embodiments, a polishing weight loss of the semiconductor substrate is less than 0.3 g.

A shape of the substructure in the second texture structure after polishing may be adjusted by controlling the polishing time and the polishing temperature, so that, in the two or more first substructures at least partially stacked on one another, in a direction away from the rear surface and perpendicular to the rear surface, a distance between a top surface of the outermost first substructure and a top surface of the first substructure adjacent thereto is less than or equal to 2 µm.

In some embodiments, the second texture structure including a non-pyramid-shaped microstructure may be formed by hot-air drying the surface of the semiconductor substrate.

In S40, a tunneling layer is formed on the second texture structure of the rear surface of the semiconductor substrate.

In some possible embodiments, the rear surface of the semiconductor substrate may be etched and then treated by ozone oxidation, high temperature thermal oxidation, nitric acid oxidation, chemical vapor deposition or low-pressure chemical vapor deposition to form the tunneling layer 30.

In some embodiments, the tunneling layer 30 is deposited on the rear surface of the semiconductor substrate by a temperature change process and chemical vapor deposition. During the deposition, a heating rate is controlled in a range of 0.5 °C/min to 3 °C/min, a deposition temperature is controlled in a range of 560°C to 620°C and a deposition time is controlled in a range of 3 min to 10 min.

For example, during the deposition, the deposition temperature may be 560°C, 570°C, 580°C, 590°C, 600°C, 610°C, 615°C, 620°C or the like, the deposition time may be 3 min, 4 min, 5 min, 6 min, 7 min, 8 min, 9 min, 10 min or the like, and the heating rate may be 0.5 °C/min, 0.8 °C/min, 1.0 °C/min, 1.2 °C/min, 1.5 °C/min, 2.0 °C/min, 2.5 °C/min, 3 °C/min or the like, which may also be other values in the above ranges and are not limited herein.

In some embodiments, the tunneling layer 30 is deposited on the rear surface of the semiconductor substrate by low-pressure chemical vapor deposition, which may reduce the influence of a high local doping concentration of the thinner tunneling layer 30 in subsequent high-temperature doping treatment and reduce the fluctuation of the open-circuit voltage. The tunneling layer 30 formed by the temperature change process and low-pressure chemical vapor deposition may increase the open-circuit voltage of the solar cell by 4 mV to 6 mV.

The tunneling layer 30 may be a stack structure of one or more of a silicon oxide layer, an aluminum oxide layer, a silicon oxynitride layer, a molybdenum oxide layer and a hafnium oxide layer. In other embodiments, the tunneling layer 30 may also be an oxygen-containing silicon nitride layer, an oxygen-containing silicon carbide layer, or the like. The tunneling layer 30 has a thickness in a range of 0.8 nm to 2 nm. For example, the thickness of the tunneling layer 30 is 0.8 nm, 0.9 nm, 1.0 nm, 1.2 nm, 1.4 nm, 1.6 nm, 1.8 nm, 2 nm or the like. The thickness of the tunneling layer 30 refers to a thickness of the tunneling layer 30 relative to a formation surface. The thickness of the tunneling layer 30 formed on the second texture structure may be calculated by taking a normal direction of a bevel of the substrate as a thickness direction and observing a cross section thereof. The tunneling layer 30 with an excessive large thickness is not conducive to reduce contact resistance of the tunneling layer. Reduction of the fill factor caused by the contact resistance may be inhibited by controlling the thickness of the tunneling layer.

For example, a bandgap width of the tunneling layer 30 is greater than 3.0 eV, and it is generally difficult to transport carriers through the tunneling layer 30 by thermal emission. However, since the tunneling layer 30 is very thin, the carriers may pass through the tunneling layer 30 through a tunneling effect. Therefore, the tunneling layer with a thickness in the range of 0.8 nm to 2 nm does not block the transport of most carriers. As the thickness of the tunneling layer gradually increases, the tunneling effect of most carriers is adversely affected, and it is difficult to transport the carriers through the tunneling layer 30, and the photoelectric conversion efficiency of the solar cell may gradually decrease. The tunneling layer with an excessive small thickness cannot play a role of passivation. For example, the tunneling layer 30 is a silicon oxide layer, and the tunneling layer 30 has a thickness in a range of 0.8 nm to 1.5 nm.

In S50, a polycrystalline silicon layer is formed on a surface of the tunneling layer, and the polycrystalline silicon layer is doped to form a doped conductive layer. A conductivity type of the doped conductive layer being the same as that of the semiconductor substrate.

In some possible embodiments, the polycrystalline silicon layer is deposited on the surface of the tunneling layer by any one of physical vapor deposition, chemical vapor deposition, plasma enhanced chemical vapor deposition or atomic layer deposition. The chemical vapor deposition may be low-pressure chemical vapor deposition or atmospheric chemical vapor deposition.

In some embodiments, the deposition of the tunneling layer and the polycrystalline silicon layer and the doping of the polycrystalline silicon layer are all performed in a low-pressure chemical vapor deposition device.

Specific steps are as follows.

Firstly, the alkali-polished semiconductor substrate is placed in a deposition device, an oxygen source (e.g. oxygen, nitrous oxide, or ozone) of 20 L to 60 L is introduced, and the deposition device is heated to 560°C to 620°C according to a heating rate in a range of 0.5 °C/min to 3 °C/min for a deposition time in a range of 3 min to 10 min to form the tunneling layer 30.

After the introduction of the oxygen, a constant temperature phase is conducted, and then an appropriate amount of silane gas is introduced to form a polycrystalline silicon layer.

Finally, the polycrystalline silicon layer is doped in situ to form the doped conductive layer 40.

In some embodiments, the doped conductive layer 40 may be a doped polycrystalline silicon layer. The doped conductive layer 40 has a doping element of a same conductivity type as the semiconductor substrate.

In some other embodiments, a microcrystalline silicon layer or an amorphous silicon layer may also be deposited on the surface of the tunneling layer 30 and doped in situ to form a doped microcrystalline silicon layer or doped amorphous silicon layer, that is, the doped conductive layer 40.

When the semiconductor substrate 10 is an N-type monocrystalline silicon substrate, the doped conductive layer 40 is an N-type doped polycrystalline silicon layer, an N-type doped microcrystalline silicon layer or an N-type doped amorphous silicon layer. The doping element may be an N-type doping element such as phosphorus.

In some embodiments, the doped conductive layer 40 has a thickness in a range of 60 nm to 200 nm, which may be, for example, an N-type doped polycrystalline silicon layer. The doped conductive layer 40 has a refractive index in a range of 3.5 to 4.5.

Subsequent to S50 and prior to S60, the method further includes: performing high-temperature annealing treatment and cleaning treatment after the doped polycrystalline silicon layer is deposited in situ.

Embodiments of the present disclosure does not limit how the high-temperature annealing treatment and the cleaning treatment are operated. For example, the high-temperature annealing treatment deals with the deposited polycrystalline silicon layer, which facilitate better crystallization of the polycrystalline silicon layer. An annealing temperature may range from 700°C to 1000°C.

Through the high-temperature annealing treatment, diffused pentavalent phosphorus atoms form the doped polycrystalline silicon layer. After the annealing treatment, a microcrystalline silicon phase of the crystalline silicon is transformed into a polycrystalline silicon phase, and phosphorus is deposited on the surface of the semiconductor substrate to form phosphorosilicate glass (PSG).

The cleaning treatment is intended to remove a phosphorosilicate glass (PSG) layer formed during the phosphorus doping process. It should be understood that, since the surface of the semiconductor substrate has phosphorus with a high concentration, a phosphorosilicate glass (PSG) layer is generally formed during phosphorus diffusion. This phosphorosilicate glass layer has a metal impurity absorption effect, may affect the normal operation of the solar cell, and is required to be removed.

In some embodiments, the rear surface of the semiconductor substrate may be placed downward in a chain pickling device (the device is at a tape speed in a range of 1.0 /min to 2.0 m/min). The semiconductor substrate enters an acid tank to etch away the phosphorosilicate glass (PSG) layer formed on the rear surface by phosphorus diffusion. The acid tank is provided with a prepared mixed acid. The mixed acid includes a hydrofluoric acid solution with a mass concentration in a range of 2% to 10% and a hydrochloric acid solution with a mass concentration in a range of 2% to 10%. A pickling temperature ranges from 15°C to 25°C, and a pickling time ranges from about 30 s to 60 s. The front surface of the semiconductor substrate is covered with a water film, and the borosilicate glass (BSG) layer on the front surface of the semiconductor substrate may also be used as a protective layer. During the removal of the phosphorosilicate glass (PSG) layer, reaction of the front surface of the semiconductor substrate with the mixed acid is prevented.

It is to be noted that washing is needed after the pickling. A washing time ranges from 10 s to 20 s, and a washing temperature may range from 15°C to 25°C. The semiconductor substrate may also be dried after washing.

In S60, a first passivation layer is deposited on the first texture structure of the surface of the semiconductor substrate, and non-uniformity of the first passivation layer is N≤4%.

In some embodiments, the first passivation layer 20 may be deposited by plasma enhanced chemical vapor deposition. Other methods such as organic chemical vapor deposition may also be used. Embodiments of the present disclosure does not limit how the first passivation layer 20 is implemented.

In the above solution, the size of the bevel edge of the pyramid-shaped microstructure is controlled within a range of 0.4 µm to 1.9 µm, so that a gas source configured to form the first passivation layer has a similar deposition probability when diffused to the top, the bottom, and a position between the top and the bottom of the pyramid-shaped microstructure. Thickness uniformity of the first passivation layer on the pyramid-shaped microstructure is improved, so as to improve a passivation effect of the first passivation layer and increase an open-circuit voltage of the solar cell. In addition, the improvement of the uniformity of the first passivation layer may further increase a degree of matching between the first passivation layer and metal paste, which effectively reduces contact resistivity, increases a short-circuit current and a fill factor of the solar cell, and thus improving conversion efficiency of the solar cell.

The first passivation layer 20 includes a dielectric layer 21 and K antireflection layers 22 that are stacked, K is an integer greater than or equal to 2 and less than or equal to 7, and refractive indexes of the antireflection layers 22 decrease sequentially as distances from the semiconductor substrate increase.

The dielectric layer 21 includes at least one of an aluminum-containing oxide, a gallium-containing oxide, a silicon-containing oxide, a titanium-containing oxide, a hafnium-containing oxide, a nickel-containing oxide, a platinum-containing oxide or a tantalum-containing oxide. For example, the dielectric layer may be an aluminum oxide layer, a gallium oxide layer, a silicon oxide layer, a titanium oxide layer, a hafnium oxide layer, or the like, which is not limited herein.

In some embodiments, the dielectric layer 21 has a thickness in a range of 1 nm to 20 nm, which may be 1 nm, 5 nm, 8 nm, 9 nm, 10 nm, 12 nm, 15 nm, 18 nm, 20 nm or the like, may be other values in the above range, and is not limited herein.

The antireflection layer 22 includes a compound composed of at least two of silicon, nitrogen and oxygen. For example, the antireflection layer is selected from a stack structure of at least one or more of a silicon oxide layer, a silicon nitride layer or a silicon oxynitride layer.

The antireflection layer has a single-layer thickness in a range of 1 nm to 50 nm, which may be 1 nm, 5 nm, 10 nm, 20 nm, 30 nm, 35 nm, 40 nm, 45 nm, 50 nm or the like, and may also be other values in the above range, which is not limited herein.

Refractive indexes of the antireflection layers 22 decrease sequentially as distances from the semiconductor substrate increase.

Overall reflectivity of the first passivation layer 20 is in a range of 1.5 to 2.5, which may be 1.5, 1.6, 1.8, 1.9, 2.0, 2.2, 2.4, 2.5 or the like, and is not limited therein. The overall reflectivity of the first passivation layer 20 may be 1.5 to 1.8.

The first passivation layer 20 has a total thickness in a range of 70 nm to 150 nm, which may be 70 nm, 80 nm, 85 nm, 90 nm, 95 nm, 100 nm, 110 nm, 120 nm, 130 nm, 150 nm or the like, and is not limited herein.

In S70, a second passivation layer is formed on a surface of the doped conductive layer.

The second passivation layer 50 may be deposited by plasma enhanced chemical vapor deposition. Other methods such as organic chemical vapor deposition may also be used. Embodiments of the present disclosure does not limit how the second passivation layer 50 is implemented.

In some embodiments, the second passivation layer 50 includes at least one of a silicon nitride layer, a silicon oxide layer or a silicon oxynitride layer. The second passivation layer 50 has a thickness in a range of 70 nm to 120 nm. For example, the second passivation layer 50 is a silicon nitride layer, and the silicon nitride layer has a low silicon-to-nitrogen ratio. The silicon nitride layer has a refractive index in a range of 1.7 to 2.1, which may be 1.7, 1.8, 1.9, 2.0, 2.1 or the like, and may also be other values in the above range, which is not limited herein. The refractive index of the silicon nitride layer is controlled to enable the silicon nitride layer to have a low silicon-to-nitrogen ratio, and the formed second passivation layer 50 can reduce the contact resistivity during metallization, thereby further reducing the contact resistivity of the solar cell.

In some embodiments, when the second passivation layer 50 is arranged with a silicon nitride layer and a silicon oxide layer stacked or with a silicon nitride layer and a silicon oxynitride layer stacked. The silicon nitride layer is located on a surface of the doped conductive layer, and the silicon oxide layer or the silicon oxynitride layer is located on a surface of the silicon nitride layer.

Further, subsequent to S70, the method further includes: screen-printing and sintering the semiconductor substrate to form an electrode.

In some embodiments, the solar cell further includes a first electrode 60 and a second electrode 70. The first electrode 60 passes through the first passivation layer 20 to form an ohmic contact with the P-type doped layer (e.g., the boron-doped diffusion layer) on the front surface of the semiconductor substrate 10. The second electrode 70 passes through the second passivation layer 50 and forms an ohmic contact with the doped conductive layer 40. The doped conductive layer 40 and the tunneling layer 30 form a passivated contact structure. The first electrode 60 and the second electrode 70 may be formed by sintering metal conductive paste coated on surfaces of the first passivation layer and the second passivation layer. In some embodiments, the first electrode 60 and the second electrode 70 may be made of metal materials such as silver, aluminum, copper or nickel.

The following are Embodiments 1 to 8 and Comparative Examples 1 to 3 of the solar cell manufactured according to the above method. Specific process parameters are shown in Table 1. Test results for the solar cell manufactured are shown in Table 2.

**Table 1 Parameters of the solar cell**

| Sample | Length C of a bevel edge of the pyramid-shaped microstructure (µm) | Dₘₐₓ (nm) | Dₘᵢₙ (nm) | N (%) | Reflectivity of the first passivation layer |
|---|---|---|---|---|---|
| Embodiment 1 | 0.4 | 100.96 | 97.11 | 3.8 | 1.77 |
| Embodiment 2 | 0.6 | 103.87 | 100.34 | 3.4 | 1.68 |
| Embodiment 3 | 0.9 | 106.46 | 103.17 | 3.1 | 1.63 |
| Embodiment 4 | 1.2 | 107.33 | 103.92 | 3.2 | 1.62 |
| Embodiment 5 | 1.4 | 103.54 | 99.98 | 3.4 | 1.68 |
| Embodiment 6 | 1.6 | 105.47 | 101.75 | 3.5 | 1.71 |
| Embodiment 7 | 1.8 | 101.32 | 97.37 | 3.9 | 1.79 |
| Embodiment 8 | 1.9 | 108.07 | 104.19 | 3.6 | 1.73 |
| Comparative Example 1 | 0.2 | 108.44 | 103.82 | 4.3 | 1.83 |
| Comparative Example 2 | 2.0 | 102.95 | 97.65 | 5.1 | 1.91 |
| Comparative Example 3 | 2.2 | 105.89 | 97.73 | 7.7 | 2.01 |

**Table 2 Test results for the solar cell**

| Sample | Open-circuit voltage (mV) | Short-circuit current (A) | Fill factor (%) | Photoelectric conversion efficiency (%) |
|---|---|---|---|---|
| Embodiment 1 | 0.7059 | 11.0961 | 82.39 | 24.133 |
| Embodiment 2 | 0.7084 | 11.0544 | 82.56 | 24.180 |
| Embodiment 3 | 0.7113 | 11.0419 | 82.44 | 24.213 |
| Embodiment 4 | 0.7103 | 11.0353 | 82.56 | 24.202 |
| Embodiment 5 | 0.7098 | 11.0450 | 82.42 | 24.162 |
| Embodiment 6 | 0.7079 | 11.0522 | 82.53 | 24.148 |
| Embodiment 7 | 0.7060 | 11.0586 | 82.58 | 24.112 |
| Embodiment 8 | 0.7070 | 11.0572 | 82.57 | 24.139 |
| Comparative Example 1 | 0.7052 | 11.0486 | 82.60 | 24.069 |
| Comparative Example 2 | 0.7035 | 11.0696 | 82.59 | 24.054 |
| Comparative Example 3 | 0.7017 | 11.0496 | 82.72 | 23.987 |

It may be seen from Embodiment 1 to Embodiment 8 that the non-uniformity N of the first passivation layer on the first texture structure of the front surface of the semiconductor substrate is controlled within an ideal range, so as to improve the passivation effect of the first passivation layer and increase an open-circuit voltage of the solar cell. In addition, the improvement of the uniformity of the first passivation layer may further increase the degree of matching between the first passivation layer and metal paste, which increases the short-circuit current and the fill factor of the solar cell, and thus improving conversion efficiency of the solar cell.

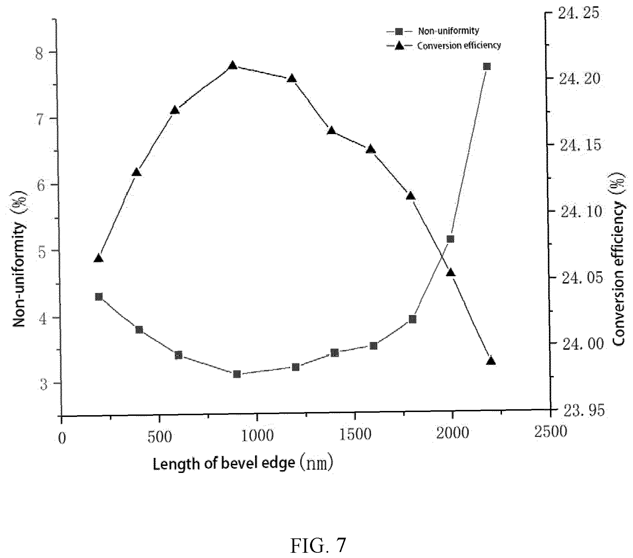

As shown in FIG. 7, with an increase in the length of the bevel edge of the pyramid-shaped microstructure in the first texture structure of the front surface of the semiconductor substrate, the conversion efficiency of the solar cell first increases and then decreases, which is because the non-uniformity of the first passivation layer formed on the pyramid-shaped microstructure is improved regardless of a too small or too large length of the bevel edge. For example, when the length of the bevel edge of the pyramid-shaped microstructure is in a range of 0.6 µm to 1.6 µm, the photoelectric conversion efficiency may reach more than 24.14%.

In the first texture structure of the solar cell according to Comparative Example 1, the length of the bevel edge of the pyramid-shaped microstructure is too small. As a result, the non-uniformity of the first passivation layer deposited is improved, the short-circuit current and the fill factor of the solar cell are reduced, and the conversion efficiency of the solar cell is also reduced.

In the first texture structure of the solar cell according to Comparative Examples 2 and 3, the length of the bevel edge of the pyramid-shaped microstructure is too large. As a result, the non-uniformity of the first passivation layer deposited is improved, the short-circuit current and the fill factor of the solar cell are reduced, and the conversion efficiency of the solar cell is also reduced.

Although the present disclosure has been disclosed as above with preferred embodiments, the claims should not be limited by those embodiments. Those skilled in the art may make possible changes and modifications to the present disclosure without departing from the conception of the present disclosure. Therefore, the protection scope of the present disclosure should be subject to the scope defined by the claims of the present disclosure.

## Claims

1. A solar cell, **characterized in that**, comprising:
a semiconductor substrate including a surface having a first texture structure, wherein the first texture structure includes a pyramid-shaped microstructure, a length of a bevel edge of the pyramid-shaped microstructure is C µm, and 0.4≤C≤1.9; and
a first passivation layer located on the first texture structure of the semiconductor substrate, wherein a non-uniformity of the first passivation layer is N≤4%, and N=(Dₘₐₓ-Dₘᵢₙ)/Dₘₐₓ, where Dₘₐₓ is a maximum thickness of the first passivation layer on the pyramid-shaped microstructure, and Dₘᵢₙ is a minimum thickness of the first passivation layer on the pyramid-shaped microstructure.

2. The solar cell according to claim 1, **characterized in that**, the maximum thickness of the first passivation layer on the pyramid-shaped microstructure is in a range of 70 nm≤Dₘₐₓ≤180 nm, or the minimum thickness of the first passivation layer on the pyramid-shaped microstructure is in a range of 50 nm≤Dₘᵢₙ≤70nm.

3. The solar cell according to claim 1, **characterized in that**, a one-dimensional size of a bottom of the pyramid-shaped microstructure is A µm, and 0.1≤A≤3, or a height from a top to a bottom of the pyramid-shaped microstructure is B µm, and 0.1≤B≤3.

4. The solar cell according to claim 1, **characterized in that**, a region having a maximum thickness in the first passivation layer is located at a top or a bottom of the pyramid-shaped microstructure, and a region having a minimum thickness in the first passivation layer is located between the top and the bottom of the pyramid-shaped microstructure.

5. The solar cell according to claim 1, **characterized in that**, the first passivation layer includes a dielectric layer and K antireflection layers, K is an integer being greater than or equal to 2 and less than or equal to 7, and refractive indexes of the antireflection layers sequentially decrease as distances of the antireflection layers from the semiconductor substrate increase.

6. The solar cell according to claim 5, **characterized in that**, the dielectric layer includes at least one of an aluminum-containing oxide, a gallium-containing oxide, a silicon-containing oxide, a titanium-containing oxide, a hafnium-containing oxide, a nickel-containing oxide, a platinum-containing oxide or a tantalum-containing oxide.

7. The solar cell according to claim 5, **characterized in that**, the dielectric layer has a thickness in a range of 1 nm to 20 nm.

8. The solar cell according to claim 5, **characterized in that**, the antireflection layer includes a compound composed of at least two of silicon, nitrogen or oxygen.

9. The solar cell according to claim 8, **characterized in that**, the antireflection layer has a single-layer thickness in a range of 1 nm to 50 nm.

10. The solar cell according to claim 5, **characterized in that**, the first passivation layer has a total thickness in a range of 70 nm to 150 nm, or an overall reflectivity of the first passivation layer is in a range of 1.5 to 2.5.

11. A photovoltaic module, comprising a plurality of solar cell strings, each of the plurality of solar cell strings comprising a plurality of the solar cells according to any one of claims 1 to 10.

12. A method for manufacturing a solar cell, comprising:
texturing a semiconductor substrate by forming a first texture structure on a surface of the semiconductor substrate, **characterized in that**, the first texture structure includes a pyramid-shaped microstructure, a length of a bevel edge of the pyramid-shaped microstructure is C, and 0.4 µm≤C≤1.9 µm; and
depositing a first passivation layer on the first texture structure of the surface of the semiconductor substrate, **characterized in that**, a non-uniformity of the first passivation layer is N≤4%.

13. The method according to claim 12, **characterized in that**, the texturing a semiconductor substrate includes:
cleaning the surface of the semiconductor substrate with a mixture of a potassium hydroxide solution at a concentration of X% and a hydrogen peroxide solution at a concentration of Y%, wherein a product of X% and Y% is in a range of 0.005 to 0.285.

14. The method according to claim 13, **characterized in that**, the potassium hydroxide solution is at a concentration of X%, 5≤X≤25.

15. The method according to claim 13, **characterized in that**, the hydrogen peroxide solution is at a concentration of Y%, 7≤Y≤25.
